(19) Europäisches Patentamt

European Patent Office

Office européen des brevets

(11) EP 0 521 652 B1

(12) **EUROPEAN PATENT SPECIFICATION**

(45) Date of publication and mention
of the grant of the patent:
**06.08.1997  Bulletin 1997/32**

(51) Int Cl.6: **H03B 19/16**

(21) Application number: **92305845.7**

(22) Date of filing: **25.06.1992**

(54) **Frequency multiplier**

Frequenzvervielfacher

Multiplicateur de fréquence

(84) Designated Contracting States:
**BE DE ES FR GB GR IT**

(30) Priority: **01.07.1991  US 724277**
**01.07.1991  US 724233**

(43) Date of publication of application:
**07.01.1993  Bulletin 1993/01**

(73) Proprietor: **RAYTHEON COMPANY**
**Lexington Massachusetts 02173 (US)**

(72) Inventors:
 • **Russell, Mark E.**
 **Londonderry, NH 03053 (US)**
 • **Pietrangelo, Gregory J.**
 **Haverhill, MA 01830 (US)**
 • **Mara, John F., Jr.**
 **Nashua, NH 03062 (US)**

 • **Tipton, Michael C**
 **Medford, MA 02155 (US)**

(74) Representative: **Jackson, David Spence et al**
**REDDIE & GROSE**
**16, Theobalds Road**
**London, WC1X 8PL (GB)**

(56) References cited:
EP-A- 0 369 135          US-A- 4 048 571
US-A- 4 456 889          US-A- 4 531 105

 • HEWLETT-PACKARD JOURNAL vol. 39, no. 2,
 April 1988, U.S.A pages 18 - 25 ROBERT
 • D. ALBIN 'Millimeter-Wave source Modules'
 • PATENT ABSTRACTS OF JAPAN vol. 10, no. 359
 (E-460)(2416) 3 December 1986

## Description

This invention relates to a frequency multiplier comprising multiplying means, having an input and an output, for providing an output signal at the output, the output signal having a frequency of an odd multiple or an even multiple of a frequency of a signal fed to the input thereof.

As is known in the art, frequency multipliers are used to derive from an input signal having an input frequency an output signal having an output frequency greater than the input frequency of the input signal. Typically, the output frequency is an exact integral multiplier of the input frequency. For example, a frequency doubler provides an output signal with a frequency that is twice the frequency of the input signal and a frequency tripler provides an output signal with a frequency that is three times the frequency of the input signal. With a combination of frequency doublers and frequency triplers, a signal with a desired frequency can be provided from a signal having a much lower frequency.

US-A-4 531 105 describes a frequency multiplier of the kind defined hereinbefore at the beginning in which a microwave signal in the range 8 to 12 gigahertz is supplied to one port of a 180° hybrid that provides a 0° phase output at one output port and a 180° phase output at the other output port. Each of these outputs is supplied to a respective one of two non-linear active devices that generates harmonics of the fundamental frequency. Each non-linear active device may utilise diodes or may, in particular, be a dual-gate FET with appropriate bias chokes, DC blocking capacitors, and an RF bypass capacitor for the second gate of the FET. The fundamental and harmonics are led from the drain of the FET, or other output terminal of the non-linear active device, to a respective one of the two input ports of a mirror-image hybrid circuit that provides the fundamental and odd harmonics at one output port, and even harmonics at the other output port. Bandpass filters are used at these output ports to select the desired harmonics, which may be for example the harmonics having three times and two times the frequency of the fundamental respectively.

In an article entitled "Millimeter-Wave Source Modules" at pages 18 to 25 of Hewlett-Packard Journal, Volume 39, April 1988, No. 2, R.D. Albin describes frequency doublers and triplers for multiplying microwave frequencies in the range 11 to 20 gigahertz to millimetre wave frequencies in the range 13.25 to 60 gigahertz in which diode multipliers are used. In particular, a frequency tripler is described there in which a self-biasing anti-parallel diode pair is used connected between a node at the output port of a low pass filter for an input frequency $f_o$ and the input port of a band pass filter for an output frequency $3f_o$. Each of the two diodes is connected in series with a respective parallel combination of a capacitor and a resistor, with one electrode of the diode at the said node, and the remote terminal of the parallel combination grounded.

A critical characteristic of a frequency multiplier for many applications is that the frequency multiplier must provide an output signal with little phase noise added to the input signal. Phase noise is used to describe the characteristic randomness of short-term frequency fluctuations and is an important indicator of a given signal generator's short-term frequency stability. In a signal generator application, each element of the signal generator including the frequency multiplier must have a low phase noise characteristic so that the output signal of the signal generator will have little phase noise. It is also desirable for the frequency multiplier to provide an output signal with a controlled output signal level with little variation to minimize variations introduced by a signal provided by the signal generator circuitry. Thus it is desirable to provide a frequency doubler and a frequency tripler that provide an output signal with little phase noise added to an input signal fed thereto, the output signal further having a constant signal level.

US-A-4 456 889 describes a dual-gate MESFET variable-gain constant-output-power amplifier in which radio frequency input power is supplied to a first MESFET amplifier having its output coupled through a directional coupler to a first gate circuit of a second MESFET amplifier. The directional coupler also supplies a portion of the first MESFET amplifier output to a gain control circuit connected to a second gate circuit of the second MESFET amplifier. The gain control circuit consists of a diode detector circuit, a video amplifier, and a capacitor-resistor coupling circuit in cascade between the directional coupler and the second gate circuit. It is arranged that an increase in the power level of the output from the first MESFET amplifier results, through the action of the gain control circuit, in a decrease in the gain of the second MESFET amplifier, and vice-versa. The second MESFET amplifier is followed in sequence by a second directional coupler, a third MESFET amplifier, a third directional coupler, and a fourth MESFET amplifier, and a fifth MESFET amplifier. The gains of the third and fourth MESFET amplifiers are controlled by second and third gain control circuits in the same way as the gain of second MESFET amplifier is controlled.

According to the present invention, a frequency multiplier of the kind defined hereinbefore at the beginning is characterised by an amplifier circuit (10) comprising:

(i) a first amplifier (12) having an input and an output, the input coupled to the output of the multiplier means;

(ii) an attenuator (16), having an input port, an output port and a control port, the input port fed by the output of the first amplifier (12);

(iii) means (20) for providing an intermediate control signal in response to variations in an output signal fed from the output of the first amplifier (12);

(iv) means (26) for providing a reference signal, the reference signal indicative of ambient temperature of the amplifier circuit (10); and

(v) means (24), fed by the reference signal and the intermediate control signal, for providing a control signal to the control port for minimizing variations of signal level in an output signal at the output port of the attenuator (16).

Preferred embodiments of this invention provide: a frequency multiplier with an output signal having little phase noise added to an input signal fed thereto;

a frequency multiplier having an output signal with a constant signal level;

a frequency multiplier that occupies a minimum amount of space while providing proper heat dissipation;

an improved frequency tripler.

In one preferred embodiment of the present invention, the frequency multiplier includes means having an input and an output, for providing an output signal at the output, the output signal having a frequency of an odd multiple of a frequency of a signal fed to the input thereof and an amplifier circuit including a first amplifier having an input and an output and a gain control circuit. The gain control circuit includes a variable attenuator, having an input port, an output port and a control port and responsive to a control signal fed to the control port, for attenuating an input signal fed to the input port thereof and for providing an attenuated signal at the output thereof, the input port fed by the output of the first amplifier. The gain control circuit further includes a detector for providing an intermediate control signal in response to variations in the input signal and a temperature compensation circuit for providing a reference signal, the reference signal indicative of ambient temperature of the amplifier circuit. The gain control circuit still further includes a differential amplifier, fed by the reference signal and the intermediate control signal, for providing the control signal to the control port. The amplifier circuit further includes a second amplifier having an input and an output, the input of the second amplifier fed by the output port of the variable attenuator and the output providing the output of the frequency multiplier. With such an arrangement, a frequency multiplier is provided wherein an output signal is provided having a frequency of an odd multiple, typically a third harmonic, of the frequency of the input signal, the output signal having a constant signal level with little phase noise added to said signal by the frequency multiplier. Such a frequency multiplier is appropriate for use as an element in a low noise signal generator.

In another preferred embodiment of the present invention, the frequency multiplier includes means having an input and an output, for providing an output signal at the output, the output signal having a frequency of an even multiple of a frequency of a signal fed to the input thereof and an amplifier circuit including a first amplifier having an input and an output and a gain control circuit. The gain control circuit includes a variable attenuator, having an input port, an output port and a control port and responsive to a control signal fed to the control port, for attenuating an input signal fed to the input port thereof and for providing an attenuated signal at the output thereof, the input port fed by the output of the first amplifier. The gain control circuit further includes a detector for providing an intermediate control signal in response to variations in the input signal and a temperature compensation circuit for providing a reference signal, the reference signal indicative of ambient temperature of the amplifier circuit. The gain control circuit still further includes a differential amplifier, fed by the reference signal and the intermediate control signal, for providing the control signal to the control port. The amplifier circuit further includes a second amplifier having an input and an output, the input of the second amplifier fed by the output port of the variable attenuator and the output providing the output of the frequency multiplier. With such an arrangement, a frequency multiplier is provided wherein an output signal is provided having a frequency of a second harmonic of the frequency of the input signal, the output signal having a constant signal level with little phase noise added to said signal by the frequency multiplier. Such a frequency multiplier is appropriate for use as an element in a low noise signal generator.

The invention will now be described by way of example with reference to the accompanying drawings, in which:-

FIG. 1 is a block diagram of an amplifier circuit for an embodiment of the invention;

FIG. 2 is a schematic diagram of the amplifier circuit of FIG. 1;

FIG. 3 is a plan view of a hybrid implementation of the amplifier of FIG. 1;

FIG. 4 is a block diagram of a frequency tripler circuit according to the invention;

FIG. 5 is a schematic diagram of the frequency tripler circuit of FIG. 4;

FIG. 6 is a plan view of a hybrid implementation of a frequency tripler of FIG. 4; and

FIG. 7 is a block diagram of a frequency doubler according to the invention.

## Description of the Preferred Embodiments

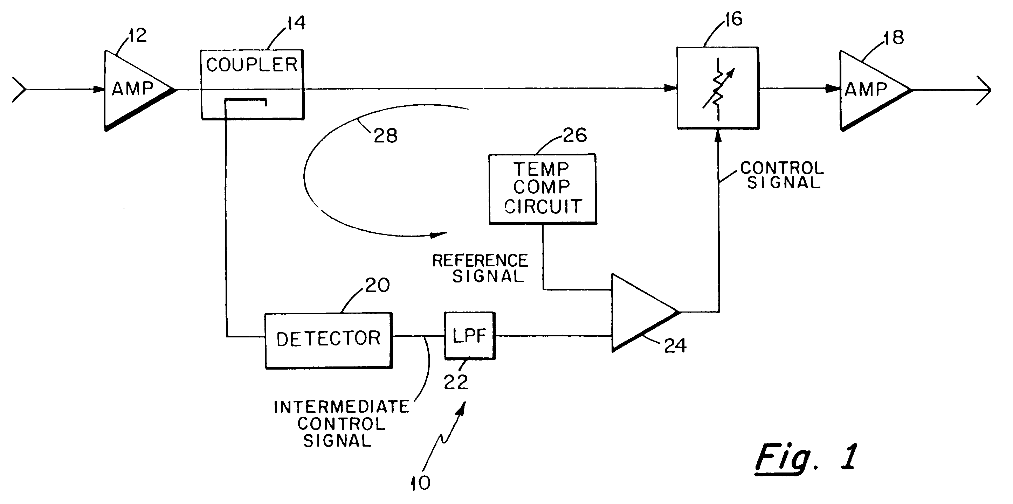

Referring now to FIG. 1, it may be seen that a temperature compensated gain limited amplifier 10 (herein referred to as amplifier 10) here includes a first amplifier 12 having an input, which is also the input for amplifier 10, and an output. The first amplifier 12 is here capable of providing 15 dB of gain with a flat gain response and has greater than 15 dB of return loss over an octave of bandwidth, here 4.0 GHz in the frequency range from 2.0 GHz to 6.0 GHz. The output of the first amplifier 12 is connected to an input of coupler 14 having also a first and a second output. The first output of coupler 14 is connected to an input port of a variable attenuator 16. Variable attenuator 16, having also a control port and an output port is capable of providing in excess of approximately 12 dB of near linear attenuation in response to a control signal at the control port. The output port of the variable attenuator 16 is connected to an input of a second amplifier 18 having also an output which is also the output of amplifier 10. The second amplifier 18, similar to the first amplifier 12, is capable of providing 15 dB of gain with a flat gain response and has greater than 15 dB of return loss over an octave of bandwidth.

With the foregoing in mind, it may be seen that the control signal fed to the control port of the variable attenuator 16 is provided by a feed forward gain control loop 28. Thus, the second output of coupler 14 is connected to an input of a detector 20. The detector 20 is capable of providing a rectified DC voltage signal having a magnitude determined by a signal level of a signal fed to the input of the detector 20. An output of the detector 20 is connected to an input of a low pass filter 22. The low pass filter 22 having also an output allows signals having a frequency below 50 MHz pass through, while blocking signals having a frequency above 50 MHz. The output of the low pass filter 22 is connected to a first input of an operational amplifier 24 (hereinafter also referred to as a differential amplifier 24). The differential amplifier 24 also having a second input and an output is capable of providing an output signal having a magnitude as determined by a difference in magnitude between a magnitude of a first signal fed to the first input and a magnitude of a second signal provided by the detector 20. The output of the differential amplifier 24 is connected to the control port of the variable attenuator 16.

The second input of the differential amplifier 24 is connected to an output of a temperature compensation circuit 26. The temperature compensation circuit 26 is capable of providing a reference signal at the output thereof, the reference signal indicative of ambient temperature of the amplifier 10, thus having a varying magnitude determined by the ambient temperature. When the ambient temperature of the amplifier 10 is constant, the reference signal provided at the output of the temperature compensation circuit 26 has a magnitude of a predetermined value to provide an appropriate signal level at the second input of differential amplifier 24 as described further hereinafter.

With the foregoing in mind, a signal applied to the input of the amplifier 10 at the input of first amplifier 12 is amplified by the first amplifier 12 to an appropriate signal level, here typically from -17 dBm to -2 dBm. A signal at the output of the first amplifier 12 is passed through coupler 14 wherein the signal is attenuated by 0.5 dB and fed to the input port of the variable attenuator 16. The signal fed to the input of the variable attenuator 16 is provided at the output thereof and attenuated an amount as determined by the control signal applied to the control port of the variable attenuator 16. Here, the attenuation of the signal with the control signal applied is typically 5 dB. The signal at the output of the variable attenuator 16 is fed to the input of the second amplifier 18. The signal is amplified approximately 15 dB by the second amplifier 18 and provided at the output of the second amplifier 18. It should be appreciated, amplifier 10, as thus described, provides approximately 22.5 dB of gain to a signal applied to the input thereof.

The control signal for the variable attenuator 16 is provided by the gain control loop 28. A portion of the signal at the output of first amplifier 12 is coupled by the coupler 14 and provided at the second output of coupler 14. From the second output of coupler 14, the signal is fed to the input of detector 20. The detector 20 is adapted to provide a constant rectified DC voltage signal at the output thereof when the signal fed to the input of the detector 20 is non-varying in magnitude. When the input signal is varying in magnitude, the detector 20 is adapted to provide the rectified DC voltage signal changed in voltage an amount proportional to the magnitude of the change of the signal level of the input signal. The output signal of the detector 20 is passed through a low pass filter 22 wherein higher frequency signals are rejected. The output signal of the detector 20 provides an intermediate control signal to the differential amplifier 24.

It should be appreciated that the intermediate control signal will have a voltage of a predetermined value when the signal at the input of the variable attenuator 16 is non-varying in magnitude. When the magnitude of the signal level at the input of the variable attenuator 16 increases, the value of the voltage of the intermediate control signal will increase proportionally. When the magnitude of the signal level at the input of the variable attenuator 16 decreases, the value of the voltage of the intermediate control signal will decrease accordingly. Thus, the change of the value of the voltage of the intermediate control signal is representative of the change of the value of the signal level at the input of the variable attenuator 16.

With the foregoing in mind, if the intermediate control signal is provided by the detector 20 and a reference signal is fed to the second input of the differential amplifier 24, then the control signal provided at the output of the operational amplifier 24 will change in accordance with the change of the intermediate control signal which, in turn, will change the amount of attenuation provided by the variable attenuator 16. It should now be apparent that if an input signal fed to the input of amplifier 10 has an increasing signal level, then the gain control loop 28 will provide a control signal to variable attenuator 16 to cause variable attenuator 16 to provide more attenuation. Alternatively, if the input signal fed to the input of amplifier 10 has a decreasing signal level, then the gain control loop 28 will provide a control signal to the variable attenuator 16 to cause the variable attenuator 16 to provide less attenuation. Thus, the output signal provided at the output of amplifier 10 has an approximately constant signal level.

As stated hereinbefore, a reference signal is provided at the second input of the differential amplifier 24 and is here provided by temperature compensation circuit 26. At an ambient temperature of a predetermined value, the reference signal is set with an appropriate voltage so that when differenced with the intermediate control signal when a non-varying signal is provided at the input of the variable attenuator 16, an appropriate control signal is provided at the output of the differential amplifier 24. The control signal is fed to the control port of the variable attenuator 16 so that the variable attenuator 16 provides a predetermined amount of attenuation. If the ambient temperature should change, then the voltage level of the reference signal will change accordingly, which will change the control signal and the amount of attenuation provided by the variable attenuator 16. With such an arrangement, the amount of attenuation can be matched to correlate with corresponding amount of change of gain provided by the first and the second amplifiers 12, 18 due to the change in operating characteristics of the first and second amplifiers 12, 18 caused by temperature variation. By appropriately correlating the change of attenuation by the variable attenuator 16 to match the change of gain provided by first amplifier 12 and second amplifier 18, the amplifier 10 is adapted to provide a constant output signal level, although experiencing variation of ambient temperature. Thus, the amplifier 10 provides an output signal wherein variations of the output signal level are minimized due to changing characteristics of the amplifier 10 caused by ambient temperature variation or varying signal level of the input signal to the amplifier 10.

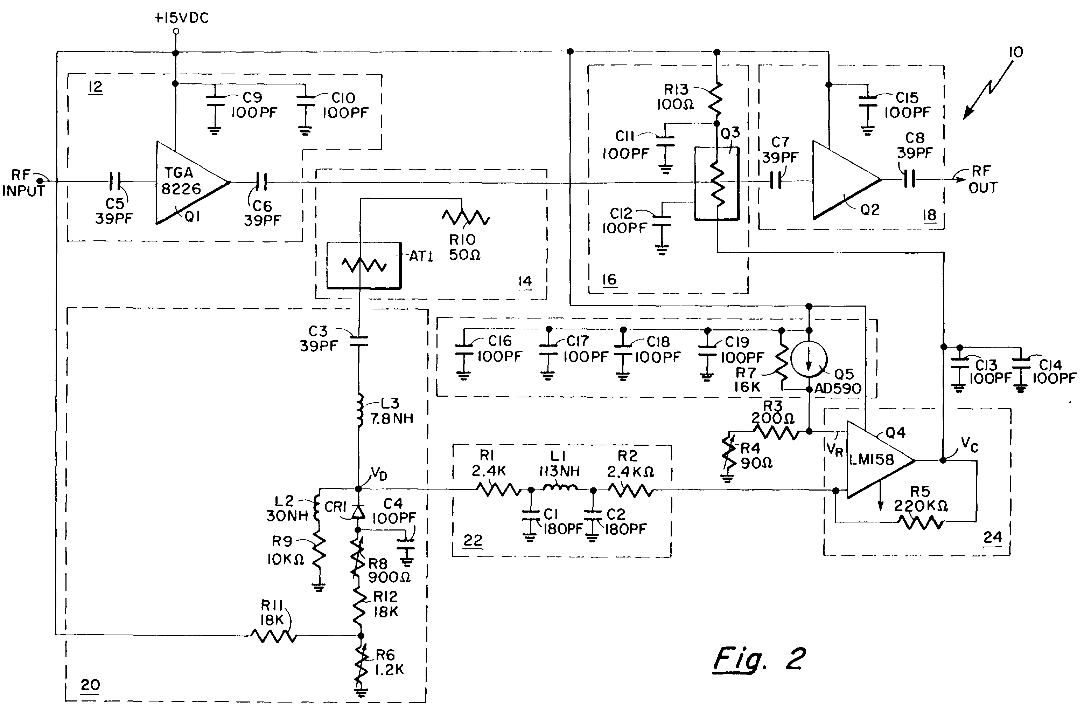

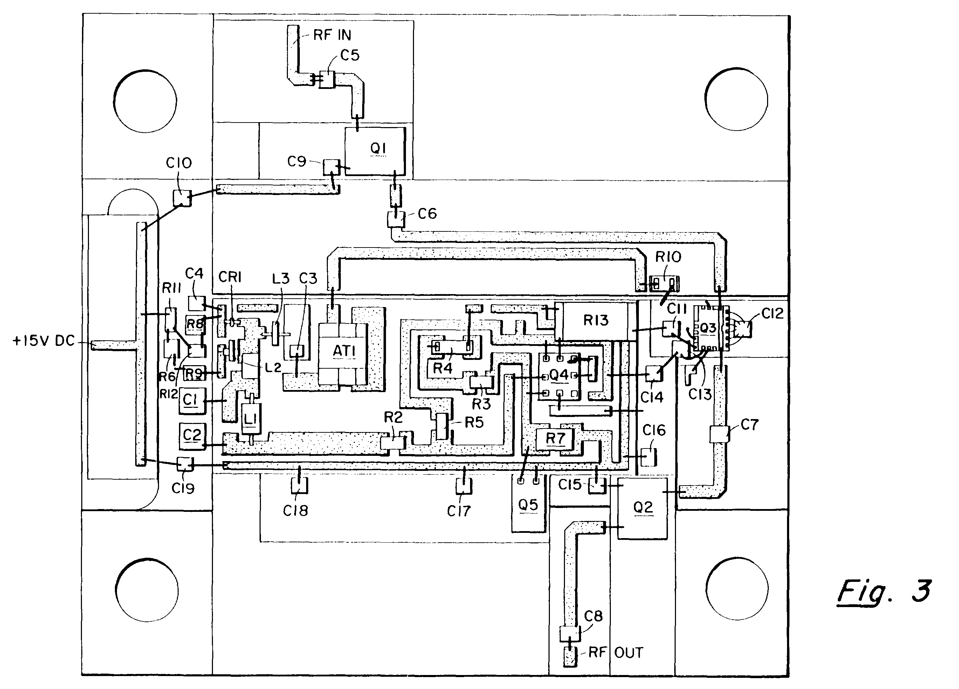

Referring now to FIGS. 2 and 3, the amplifier 10 as described in connection with FIG. 1 is shown implemented as a hybrid circuit. It should be appreciated wherein the amplifier 10 is implemented as a hybrid circuit, microstrip circuitry with strip conductors are disposed on a substrate (not numbered) here 0.015 inch thick alumina having 80 to 120 microns of gold disposed thereon. Since the gold will not adhere directly to the alumina, a conductive layer comprised of titanium-tungsten typically about 20Å thick, is disposed between the gold layer and the alumina to promote adhesion of the gold to the alumina. The strip conductors are here provided using conventional photo-etching techniques. A conductive layer on an opposing surface of the substrate (not numbered) provides a ground for the hybrid circuit. It should be appreciated that capacitors C1 through C19 are parallel plate capacitors, that is two square gold metal plates with a dielectric in between. With such an arrangement, the bottom plate is bonded to the microstrip circuitry to complete one side of a connection and a bond wire is connected to the top plate to complete the other side of the connection. It should also be appreciated that although single bond wires are shown for connections on FIG. 3, for ease of clarity, multiple bond wires would be used where possible to ensure proper connection in accordance with standard bonding practices.

The amplifier 10 is adapted here to operate from a single source power supply having an output voltage of 15 volts of direct current. The input signal, here typically at a level of -17 dBm, is fed to the input of the first amplifier 12. The first amplifier 12 is here implemented with a monolithic microwave integrated circuit (MMIC) amplifier $Q_1$ providing 15 dB of gain, here a TGA8226 manufactured by Texas Instruments, Inc. of Dallas, TX. The amplifier $Q_1$ is powered by the 15 volts of direct current carried on a 15 VDC power line and a 100 pF capacitor C9 and a 100 pF capacitor C10 provides an RF decoupling path to ground. The capacitors C9 and C10 are disposed such that the bottom plate is bonded to ground and bond wires are used to connect the top plate of the capacitors C9 and C10 to the 15 VDC power line. A 39 pF capacitor C5 provides DC isolation at the input of the first amplifier 12 and a 39 pF capacitor C6 provides DC isolation at the output of the first amplifier 12. The output of the first amplifier 12, which has a signal at a level of approximately -2 dBm is fed through the coupler 14 to the input of the variable attenuator 16. The signal is typically attenuated less than 0.5 dB by the coupler 14 thus having a signal level of approximately -2.5 dBm at the input of the variable attenuator 16. The variable attenuator 16 is implemented using a GaAs (gallium arsenide) MMIC attenuator $Q_3$, here a Triquint 9161 manufactured by Triquint Semiconductor, Inc. of Beaverton, Oregon providing 5 dB attenuation at +25°C with the appropriate control signal at the control port thereof. The GaAs MMIC attenuator $Q_3$ is powered by the 15 VDC power line through a 100 Ω dropping resistor R13 which provides approximately 12 VDC to the attenuator Q3 and a 100 pF capacitor C11 provides an RF decoupling path to ground. A 100 pF capacitor C12 is also connected to attenuator Q3 to provide an RF decoupling path to ground.

The output of the variable attenuator 16 provided by the output of attenuator Q3, which has a signal level of approximately -9.5 dBm, is fed to the input of the second amplifier 18. The second amplifier is here implemented with a MMIC amplifier $Q_2$ providing 15 dB of gain and like MMIC amplifier $Q_1$ is here a TGA8226. A 39 pF capacitor C7 provides DC isolation at the input of the second amplifier 18 and a 39 pF capacitor C8 provides DC isolation at the output of the second amplifier 18. The MMIC amplifier $Q_2$ is powered by the 15 VDC power line and a 100 pF capacitor C15 provides an RF decoupling path to ground.

To provide a signal for the gain control loop 28 (FIG. 1), the coupler 14 has a main line between the first amplifier 12 and the variable attenuator 16 and a coupled line disposed to couple a portion of the signal propagating on the main line to the coupled line. A 50 ohm resistor R10 is disposed at the end of the coupled line to terminate the coupled line. The other end of the coupled line is connected to attenuator AT1 wherein the signal is attenuated approximately 3dB and fed to the input of the detector 20.

The detector 20 includes a voltage dividing network including a 2.4 KΩ variable resistor R6 set to 1.2 KΩ, a 2.4KΩ variable resistor R8 set to 900 Ω, an 18 KΩ resistor R11 and an 18 KΩ resistor R12 connected as shown to the anode of diode CR1. A 100 pF capacitor C4 is connected between the anode of diode CR1 and ground to provide an RF decoupling path to ground. The input signal to detector 20 is fed through a 39 pF capacitor C3 and then a 7.8 nH inductor L3 and applied to the cathode of the diode CR1. Furthermore, a 30 nH inductor L2 is connected in series between the cathode of diode CR1 and a 10 KΩ resistor R9 which in turn is connected to ground. A signal path from the cathode of diode CR1 provides the output from the detector 20. It should be appreciated that variable resistor R8 and variable resistor R6 are adjusted such that diode CR1 is biased for proper operation to provide the intermediate control signal.

The low pass filter 22 includes a 2.4 KΩ resistor R1 connected in series with a 113 nH inductor L1 which is connected to a 2.4 KΩ resistor R2 as shown. A 180 pF capacitor C1 is connected between ground and a junction between resistor R1 and inductor L1. A 180 pF capacitor C2 is connected between ground and a junction between inductor L1 and resistor R2 completing the low pass filter 22. An output line of the low pass filter 22, which is connected to the resistor R2 at a first end, is connected to one of the inputs of the operational amplifier 24. It should be appreciated that resistors R1 and R2 also determine the operational characteristic of the differential amplifier 24 as to be described.

The differential amplifier 24 is configured using an operational amplifier $Q_4$ with a 220 KΩ resistor R5 connected between the output thereof and a first input thereof, the first input also connected to the output of the low pass filter 22. The operational amplifier $Q_4$ is here a LM158 manufactured by Motorola Semiconductor Products Division, Phoenix, AZ. The operational amplifier $Q_4$ is further connected to ground and the 15 VDC power line as appropriate. A second input of the operational amplifier $Q_4$ is fed from the temperature compensation circuit 26. It should be appreciated that resistor R5 and resistors R1 and R2 determine the gain figure of the operational amplifier 24. Letting $V_D$ equal the voltage at the output of the detector 20, $V_R$ equal the voltage at the second input of the operational amplifier Q4 and $V_C$ equal the voltage at the output of the operational amplifier Q4, the relationship between the voltages is described by

$$V_C = V_R(G+1) - V_D\,G$$

where

$$G = \frac{R5}{R1 + R2}$$

here

$$\frac{220\ \text{K}\Omega}{4.8\ \text{K}\Omega}.$$

The temperature compensation circuit 26 includes a temperature transducer $Q_5$, here an AD590 manufactured by Analog Devices, Inc. of Norwood, MA having a first terminal and a second terminal. The first terminal of the temperature transducer $Q_5$ is connected to the 15 VDC power line and the second terminal is connected to the second input of the operational amplifier $Q_4$. A 100 pf capacitor C16 and a 100 pF capacitor C17, a 100 pF capacitor C18 and a 100 pF capacitor C19 are connected between the 15 VDC power line and ground to provide an RF decoupling path to ground.

A voltage dividing network includes a 16 KΩ resistor R7, a 200 Ω resistor R3 and a 240 Ω variable resistor R4 set typically at 90 Ω is connected in series between the 15 VDC power line and ground as shown. The resistor R7 is also disposed in parallel with the temperature transducer $Q_5$ so that by adjusting variable resistor R4 when the ambient temperature of temperature transducer $Q_5$ is known, an appropriate reference voltage is applied to the second input of operational amplifier $Q_4$.

It should be appreciated that the differential amplifier 24 provides the control voltage output, $V_C$, which is dependent upon the RF signal input and the reference voltage provided by the temperature compensation circuit 26. The detector 20 provides the rectified DC voltage $V_D$ as determined by the RF input power. The operational amplifier $Q_4$ attempts to keep its two input signals at the same voltage level, $V_R$, wherein $V_R$ is set by a resistor network including the resistor $R_7$ and $R_3$ and the temperature transducer $Q_5$. If the voltage $V_R$ changes, the output voltage $V_C$ changes accordingly. If the rectified DC voltage $V_D$ changes, then the current flow through resistor $R_5$ and resistors $R_1$ and $R_2$, is changed accordingly by the operational amplifier $Q_4$, which in turn changes the voltage $V_C$ appropriately. The low pass filter 22 filters RF energy from the detector 20 to prevent oscillation in the output of the operational amplifier Q4.

The output of differential amplifier 24 is fed to the control port of the GaAs MMIC attenuator $Q_3$. A 100 pF capacitor C13 and a 100 pF capacitor C14 are connected between the control port of the GaAs MMIC attenuator $Q_3$ and ground to provide an RF decoupling signal path to ground filtering out any stray RF signals.

With such an arrangement, the MMIC amplifier $Q_1$ and the MMIC amplifier $Q_2$ can function in a linear region of operation instead of at saturation with effects from variation of the signal level of the input signal having a minimal effect on the operation of the MMIC amplifiers $Q_1$ and $Q_2$. Thus, if the signal level of the input increases, the level of the signal coupled by coupler 14 to the detector 20 increases which in turn increases the level of the signal provided by the detector 20. With an increase in the signal level provided by the detector 20, the output signal fed to the control port of the GaAs MMIC attenuator $Q_3$ will cause the GaAs MMIC attenuator $Q_3$ to increase the amount of attenuation provided by the GaAs MMIC attenuator $Q_3$, thus reducing the signal level of the signal fed to the MMIC amplifier $Q_2$. With the signal level of the input signal to the MMIC amplifier $Q_2$ reduced, the signal level of the output signal of amplifier 10 is approximately constant.

If the ambient temperature should change, then the temperature transducer $Q_5$ will change the reference voltage of the signal fed to the second input of the operational amplifier $Q_4$. With a change in the reference voltage, the signal fed to the control port of the GaAs MMIc attenuator $Q_3$ will cause the attenuation provided by the GaAs MMIC attenuator $Q_3$ to change to correspond with the change of gain provided by MMIC amplifiers $Q_1$, $Q_2$ due to the change of operational characteristics caused by the ambient temperature change. With such an arrangement, the effect of ambient temperature change on the signal level of the output signal of amplifier 10 is reduced.

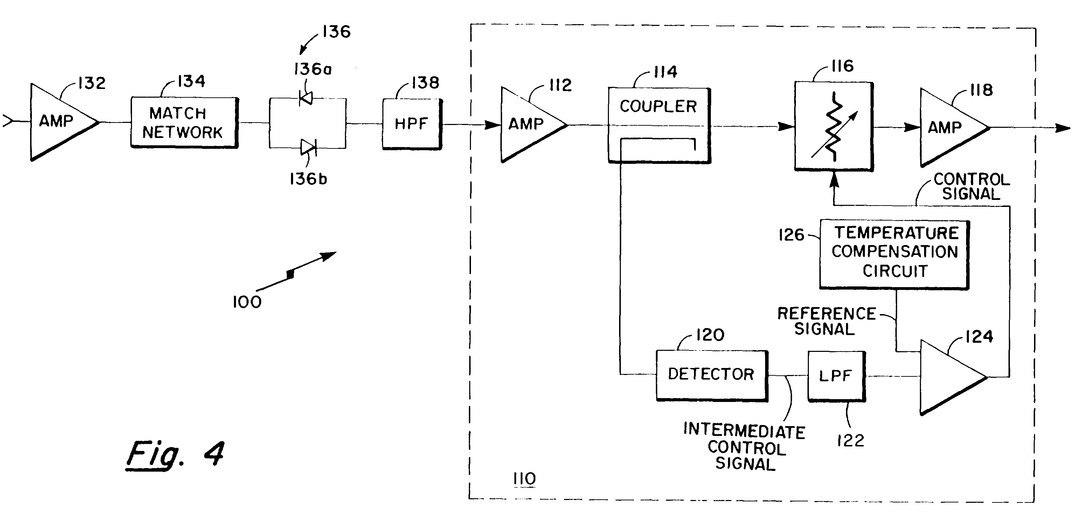

Referring now to FIG. 4, a frequency multiplier 100 (here a frequency tripler) is shown to include an input amplifier 132 having an input and an output, the input also being the input of the frequency multiplier 100. The input amplifier 132 here uses a silicon MMIC amplifier having a part number HPMA-0300 and manufactured by Hewlett Packard Co., Palo Alto, CA. The output of the input amplifier 132 is connected to an input of a matching network 134. The matching network 134 conditions a signal fed to the input thereof and provides a signal of an appropriate level at an output of the matching network 134. The output of the matching network is connected to an input of a diode pair 136. The diode pair 136, having also an output, will be described in detail hereinafter. A high pass filter 138 having an output and an input, the input connected to the output of the diode pair 136, allows a signal having a frequency within the frequency band of the high pass filter 138 fed to the input thereof to pass through to the output thereof while preventing signals below the frequency band from passing through. The output of the high pass filter 138 is connected to the input of amplifier 110. The amplifier 110 operates as described hereinbefore in connection with FIGS. 1, 2 and 3. The output of the amplifier 110 provides an output which is also an output of the frequency multiplier 100.

A signal, here from a reference oscillator (not shown), having a frequency in a range from 800 MHz to 1000 MHz is fed to the input of the input amplifier 132 wherein said signal is amplified to an appropriate level here approximately 9.3 dB and provided at the output of the input amplifier 132. The signal at the output of the input amplifier 132 is fed to the input of the matching network 134 wherein the signal is conditioned as necessary and fed to the input of the diode pair 136.

The diode pair 136 is referred to as an anti-parallel diode pair, meaning that the two diodes 136a, 136b are connected in parallel with the anode of each one connected to the cathode of the other one. If the individual diodes, here 136a and 136b, are matched or approximately identical to each other, the relative phase and amplitude of a signal created having a frequency of an even harmonic of the frequency of the input signal is such that the signal having a frequency of an even harmonic is canceled as the signal attempts to leave the diode pair 136. Signals having a frequency of an even harmonic exist in the diode pair only. Signals with a frequency of an odd harmonic of the frequency of the input signal also exist and are provided at the output of the diode pair 136. Thus, if the input signal has a frequency, $f_o$, then signals with a frequency of $f_o$, $3f_o$, $5f_o$ and etc. are provided at the output of the diode pair 136. Since it is here desired to provide a signal with a frequency, $3f_o$, by feeding the output signals provided at the output of diode pair 136 through high pass filter 138, the signal having the frequency of the input signal can be filtered away letting the signal having a frequency of the third harmonic, $3f_o$, to pass through. Thus, at the output of high pass filter 138, a signal having a frequency three times the frequency of the frequency of the input signal is provided at the output of high pass filter 138.

The signal at the output of the high pass filter 138 is fed to an input of amplifier 110. The amplifier 110 operates as described for amplifier 10 of FIGS. 1, 2 and 3. A signal fed to the input of amplifier 110 is amplified by first amplifier 112 and, after passing through coupler 114, fed to an input of a variable attenuator 116. The signal at the input of the variable attenuator 116 is attenuated accordingly, as controlled by the signal at a control port of the variable attenuator 116, and fed from the output of the variable attenuator 116 to an input of the second amplifier 118. The signal at the input of the second amplifier 118 is amplified and provided at the output of the second amplifier 118 which is also the output of the frequency multiplier 110. A portion of the signal fed to the input of the variable attenuator 16 is coupled by coupler 114 to detector 120 wherein a DC rectified voltage signal is developed and provided as an intermediate control signal to a differential amplifier 124. A reference signal from a temperature compensation circuit 126 is provided to a second input of the differential amplifier 124 wherein the reference signal is differenced with the intermediate control signal to provide a control signal at the output of the differential amplifier 124. The control signal is fed to the control port of the variable attenuator 116 so that the variable attenuator 116 provides a predetermined amount of attenuation. As described hereinbefore, if the ambient temperature should change, then the voltage level of the reference signal will change accordingly, which will change the control signal and the amount of attenuation provided by the variable attenuator 116. By appropriately correlating the change of attenuation by the variable attenuator 116 to match the change of gain provided by the first amplifier 112 and the second amplifier 118 due to the change in operating characteristics caused by ambient temperature variation, the amplifier 110 is adapted to provide a constant output signal level.

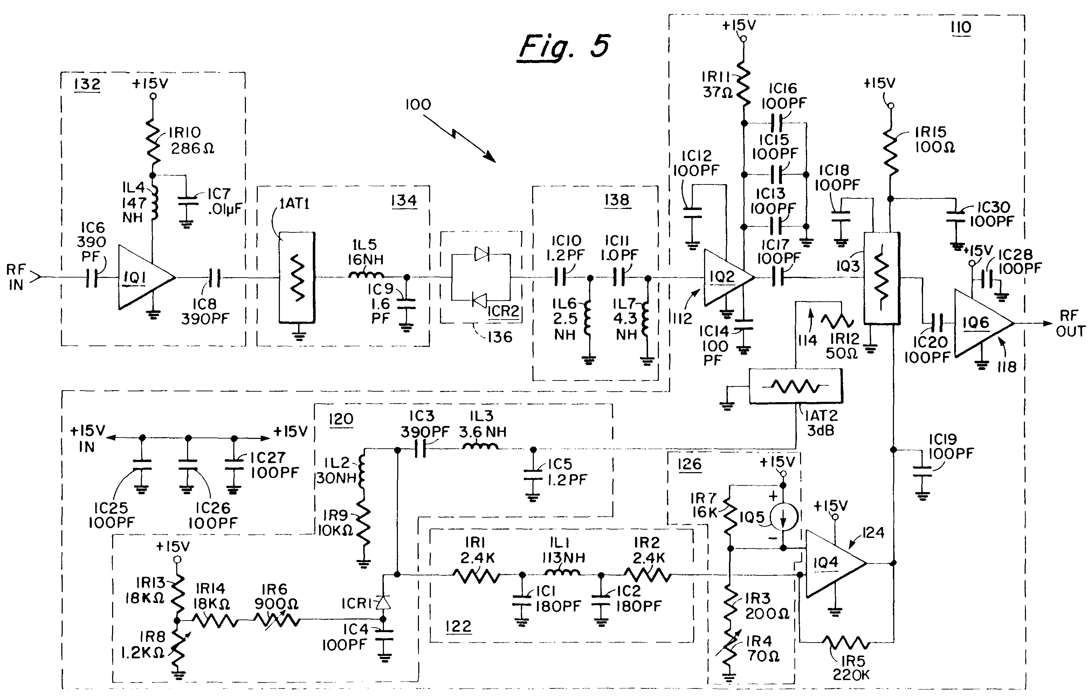

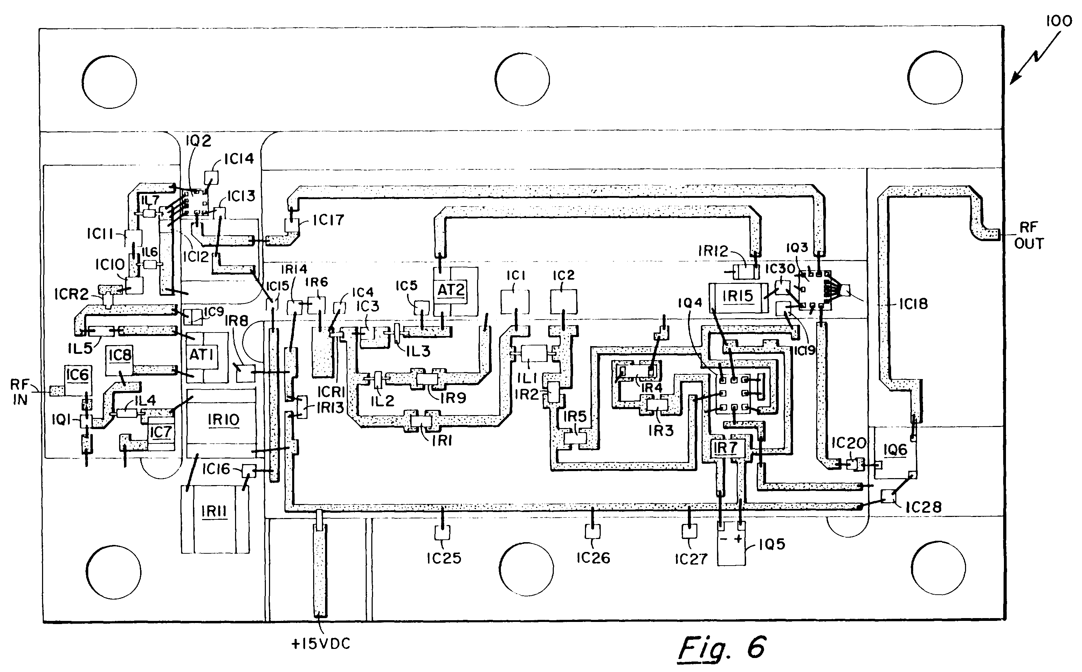

Referring now to FIGS. 5 and 6, a more detailed description of the frequency multiplier 100 as described in connection with FIG. 4 is shown as implemented as a hybrid circuit. The frequency multiplier 100 is adapted here to operate from a single source power supply having an output voltage of 15 volts direct current. A 100 pF capacitor 1C25, a 100 pF capacitor 1C26 and a 100 pF capacitor 1C27 are connected between a 15 VDC power line provided from the single source power supply and ground to provide an RF decoupling path to ground. An input signal, here from a reference oscillator, with a frequency in the frequency range from 800 MHz to 1000 MHz and a power level of -5 to -1 dBm with -3 dBm normal is fed to the input amplifier 132. A 390 pF capacitor 1C6 disposed in the input line provides isolation from the 15 VDC power line while providing connectivity for the input signal to an input of the silicon MMIC bipolar amplifier $1Q_1$. A 286 Ω resistor 1R10, a 147 nH inductor 1L4 and a 0.01 µF capacitor 1C7 are connected with the silicon MMIC amplifier $1Q_1$ as shown to provide the gain characteristics of the input amplifier 132. The output of the silicon MMIC amplifier $1Q_1$ is connected to the matching network 134 with a 390 pF capacitor 1C8 disposed in between providing further isolation from the 15 VDC power line between the input amplifier 132 and the matching network 134.

The matching network 134 can include an attenuator 1AT1 at the input of the matching network 134 wherein the signal fed to the input thereof can be attenuated when necessary or a jumper can be used to connect the signal path when the attenuator is omitted. A 16 nH inductor 1L5 and a 1.6 pF capacitor 1C9 are connected as shown to further condition the signal as the signal is fed to the diode pair 136.

The input signal to the diode pair 136 is tripled in frequency by the diode pair 136 as described hereinbefore and provided at the output thereof to the input of the high pass filter 138.

The high pass filter 138 includes a 1.2 pF capacitor 1C10 connected in series with a 1.0 pF capacitor 1C11 between the input and the output of the high pass filter 138. A 2.5 nH inductor 1L6 is connected between ground and a junction between the capacitor 1C10 and the capacitor 1C11. A 4.3 nH inductor 1L7 is connected between ground and the output of the high pass filter 138 completing the high pass filter 138. As described hereinabove, the high pass filter 138 provides a signal path for the signal with a frequency three times the frequency of the input signal while preventing signals below the frequency band from passing through. The signal at the output of the high pass filter 138 is fed to the input of the amplifier 110.

The amplifier 110 which operates in a manner similar to that as described with amplifier 10 of FIGS. 2 and 3 includes a monolithic microwave integrated circuit (MMIC) amplifier $1Q_2$ providing 15 dB of gain, here a TGA8161 manufactured by Texas Instruments, Inc. of Dallas, TX can be used as well as the TGA8226 as described hereinafter. The amplifier $1Q_2$ is powered by the 15 volts of direct current provided on a 15 VDC power line through a 37 Ω resistor 1R11 and a 100 pF capacitor 1C16, a 100 pF capacitor 1C15, and a 100 pF capacitor 1C13 provide an RF decoupling path to ground as shown. A 100 pF capacitor 1C12 is also connected between ground and the MMIC amplifier $1Q_2$ as well as a 100 pF capacitor 1C14. The output of the MMIC amplifier $1Q_2$ is fed through a 100 pF capacitor 1C17 and the coupler 114 to the input of a GaAs (gallium arsenide) MMIC attenuator $1Q_3$ here a Triquint 9161 manufactured by Triquint Semiconductor, Inc. of Beaverton, Oregon. The GaAs MMIC attenuator $1Q_3$ is powered by the 15 VDC power line through an 100 Ω resistor 1R15 providing approximately 12 VDC to the attenuator $1Q_3$. A 100 pF capacitor 1C30 is connected between the 12 VDC power input line to the attenuator 1Q3 and ground to provide an RF decoupling path to ground. A 100 pF capacitor 1C18 is also connected between ground and the GaAs MMIC attenuator $1Q_3$, as shown.

The output of the GaAs MMIC attenuator $1Q_3$ is fed through a 100 pF capacitor 1C20 to an input of a MMIC amplifier $1Q_6$, here a TGA8226. The MMIC amplifier $1Q_6$ is powered by the 15 VDC power line and a 100 pF capacitor 1C28 provides an RF decoupling path to ground. The output of the MMIC amplifier $1Q_6$ provides the output of the frequency multiplier 100.

To provide a signal for the gain control loop (not numbered), the coupler 114 has a main line between the capacitor 1C17 and the GaAs MMIC attenuator $1Q_3$ and a coupled line disposed to couple a portion of the signal propagating on the main line to the coupled line. A 50 ohm resistor 1R12 is disposed at the end of the coupled line to terminate the coupled line. The other end of the coupled line is coupled to a 3dB attenuator 1AT2 wherein the signal is attenuated approximately 3dB and fed to the input of the detector 120.

The detector 120 includes a voltage dividing network including a 2.4 KΩ variable resistor 1R8 set to 1.2kΩ, a 2.4 kΩ variable resistor 1R6 set to 900 Ω, an 18 kΩ resistor 1R13 and an 18 KΩ resistor 1R14 connected as shown to the anode of diode 1CR1. A 100 pF capacitor 1C4 is connected between the anode of diode 1CR1 and ground to provide an RF decoupling path to ground. The input signal to detector 120 is fed through a 3.6 nH inductor 1L3 and a 390 pF capacitor 1C3 and applied to the cathode of the diode 1CR1. A 1.2 pF capacitor 1C5 is connected between ground and a junction between the inductor 1L3 and the attenuator 1AT2. Furthermore, a 30 nH inductor 1L2 is connected in series with a 10 KΩ resistor 1R9 between ground and the cathode of the diode 1CR1 as shown. A signal path from the cathode of diode 1CR1 provides the output from the detector 120. It should be appreciated that variable resistor 1R8 and variable resistor 1R6 are adjusted such that diode 1CR1 is biased for proper operation to provide an intermediate control signal to the low pass filter 122.

The low pass filter 122 includes a 2.4 k$\Omega$ resistor 1R1 connected in series with a 113 nH inductor 1L1 which is connected to a 2.4K$\Omega$ resistor 1R2 as shown. A 180 pF capacitor 1C1 is connected between ground and a junction between resistor 1R1 and inductor 1L1. A 180 pF capacitor 1C2 is connected between ground and a junction between inductor 1L1 and resistor 1R2 completing the low pass filter 122. An output line of the low pass filter 122, which is connected to the resistor 1R2 at a first end, is also connected to one of two inputs of an operational amplifier 1Q$_4$.

The operational amplifier 1Q$_4$ is configured with a 220 K$\Omega$ resistor 1R5 connected between the output thereof and a first input thereof, the first input also connected to the output of the low pass filter 122. The operational amplifier 1Q$_4$ is here a LM158 manufactured by Motorola Semiconductor Products Division, Phoenix, AZ. The operational amplifier 1Q$_4$ is further connected to ground and the 15 VDC power line as appropriate. A second input of the operational amplifier 1Q$_4$ is fed from the temperature compensation circuit 126.

The temperature compensation circuit 126 includes a temperature transducer 1Q$_5$, here an AD590 manufactured by Analog Devices, Inc. of Norwood, MA having a first terminal and a second terminal. The first terminal of the temperature transducer Q$_5$ is connected to the 15 VDC power line and the second terminal is connected to the second input of the operational amplifier 1Q$_4$.

A voltage dividing network includes a 16 K$\Omega$ resistor 1R7, a 200 $\Omega$ resistor 1R3 and a 240 $\Omega$ variable resistor 1R4 set to 70 $\Omega$ connected in series between the 15 VDC power line and ground as shown. The resistor 1R7 is also disposed in parallel with the temperature transducer 1Q$_5$ so that by adjusting the variable resistor 1R4 when the ambient temperature of temperature transducer 1Q$_5$ is known, an appropriate reference voltage is applied to the second input of operational amplifier 1Q$_4$.

The output of operational amplifier 1Q$_4$ is fed to the control port of the GaAs MMIC attenuator 1Q$_3$. A 100 pF capacitor 1C19 is connected between the control port of the GaAs MMIC attenuator 1Q$_3$ and ground to provide an RF decoupling path to ground filtering out any stray RF signals.

With such an arrangement, if the signal level of the input increases, the signal level of the signal coupled by coupler 114 to the detector 120 increases which in turn increases the signal level provided by the intermediate control signal. With an increase in the signal level of the intermediate control signal the output signal fed to the control port of the GaAs MMIC attenuator 1Q$_3$ will cause the GaAs MMIC attenuator 1Q$_3$ to increase the amount of attenuation provided by the GaAs MMIC attenuator 1Q$_3$, thus reducing the signal level of the signal fed to

the MMIC amplifier 1Q$_6$. With the signal level of the input signal to the MMIC amplifier 1Q6 reduced, the signal level of the output signal of amplifier 110 is approximately constant.

If the ambient temperature should change, then the temperature transducer 1Q$_5$ will change the reference voltage of the signal fed to the second input of the operational amplifier 1Q$_4$. With a change in the reference voltage, the signal fed to the control port of the GaAs MMIC attenuator 1Q$_3$ will cause the attenuation provided by the GaAs MMIC attenuator 1Q$_3$ to change to correspondence with the change of gain provided by MMIC amplifiers 1Q$_2$, 1Q$_6$ due to the change of operational characteristics caused by the ambient temperature change. With such an arrangement, the effect of ambient temperature change on the signal level of the output signal of amplifier 110 is reduced, thus providing a relatively constant signal level at the output of the frequency multiplier 100.

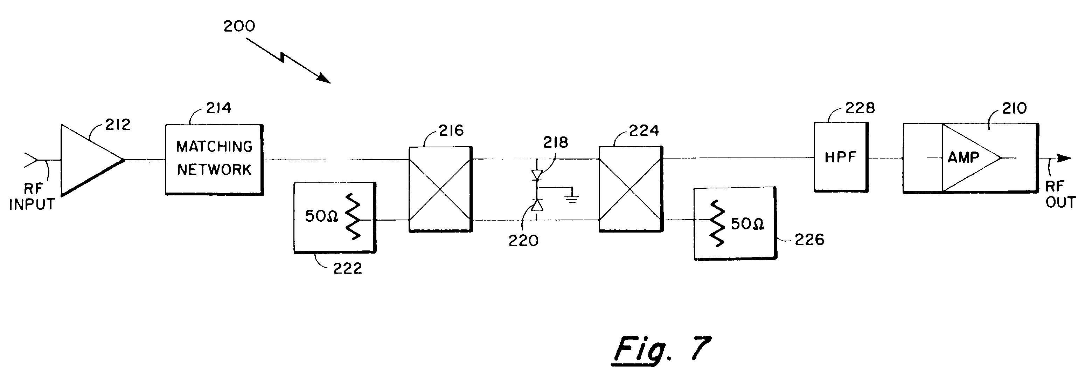

Referring now to FIG. 7, a frequency doubler 200 is shown to include an input amplifier 212 having an input and an output wherein a radio frequency signal is fed to the input thereof. The output of the input amplifier is connected to an input of a matching network 214 having also an output. A first quadrature hybrid 216 having four ports is connected such that the first port is connected to the output of the matching network 214 and the fourth port is connected to a 50 $\Omega$ resistor 222 to ground as shown. The second port and the third port of the first quadrature hybrid 216 are connected to diodes 218, 220 respectfully as shown and as to be described.

The diodes 218, 220 are Schottky diodes with the cathode of diode 218 and the cathode of diode 220 connected to ground. The anode of diode 218 is connected to the second port of the first quadrature hybrid 216 and the anode of diode 220 is connected to the third port of the first quadrature hybrid 216. A second quadrature hybrid 224 having four ports is connected such that the first port of the second quadrature hybrid 224 is connected to the anode of diode 218 and the fourth port of the second quadrature hybrid 224 is connected to the anode of diode 220. The third port of the second quadrature hybrid 224 is connected to a 50 $\Omega$ resistor 226 to ground as shown and the second port of the second quadrature hybrid 224 is connected to an input of a high pass filter 228 having also an output. The output of the high pass filter 228 is fed to an input of an amplifier 210. The amplifier 210 having an output which is also the output of the frequency doubler 200 is a type such as that described in connection with FIGS. 1, 2 and 3 having components with values appropriate for a frequency range of interest.

A radio frequency (RF) signal having a frequency, f$_o$, is fed to the input of amplifier 212 wherein the RF signal is amplified and fed to the input of the matching network 214. The signal is conditioned by the matching network 214 as appropriate and fed to the first port of the first quadrature hybrid 216. The amplifier 212 and the matching network 214 can be constructed as described for the amplifier 132 (FIG. 5) and the matching network 134 (FIG. 5), respectively.

A signal fed to the first port of the first quadrature hybrid 216 is coupled equally to the second and the third ports of the first quadrature hybrid 216 with the signal at the second port having a phase difference of 90° with the signal at the third port. The first quadrature hybrid 216 may be of any type, having four ports and functioning as the one described herein. The first quadrature hybrid 216 is a four port hybrid junction, having a first port as an input port and a second and a third port as output ports. The fourth port is terminated by the 50 $\Omega$ resistor 222. The first quadrature hybrid 216 is adapted to substantially transfer, entirely and equally, signals having a frequency, $f_o$, from the first port to the second and the third ports with the signal at the second port having a phase that leads the signal at the third port by 90°. The second port of the quadrature hybrid 216 is connected to the anode of the diode 218 and the third port of quadrature hybrid 216 is connected to the anode of the diode 220. It should be appreciated that if the signal with a fundamental frequency, $f_o$, at the anode of diode 218 has a phase difference of 90° with the signal at the anode of diode 220, then a second harmonic signal having a frequency, $2f_o$, provided at the anode of diode 218 will have a phase difference of 180° with a second harmonic signal having a frequency, $2f_o$, provided at the anode of diode 220. The diodes 218, 220 are connected such that the cathode of diode 218 is connected with the cathode of diode 220 to ground. With such an arrangement, if a fundamental frequency signal is fed to the anode of diode 218, the fundamental frequency signal having a phase that leads by 90° the phase of the fundamental frequency signal fed to the anode of diode 220, then the respective second harmonic signal produced in each of the diodes 218, 220 would be 180° out-of-phase with each other. The second harmonic signal at the anode of diode 218 is fed to the first port of quadrature hybrid 224 and the second harmonic signal at the anode of diode 220 is fed to the fourth port of quadrature hybrid 224.

The quadrature hybrid 224 operates similar as the quadrature hybrid 216 and is adapted to transfer signals at the fundamental frequency, fo, from the first port to the second and third ports with the signal of the fundamental frequency, fo, at the second port having a phase that leads the signal at the third port by 90°. Furthermore, the quadrature hybrid 224 is adapted to transfer signals from the fourth port to the second and third ports with the signal of the fundamental frequency, fo, at the second port having a phase that lags by 90° the phase of the signal at the third port.

It should also be appreciated wherein the phase of the fundamental frequency signal at the first port of the quadrature hybrid 224 leads the phase of the fundamental frequency signal at the fourth port of the quadrature hybrid 224, then the respective fundamental frequency signals at the second port of the quadrature hybrid 224 will be 180° out of phase with each other, thus attempting to cancel each other (commonly referred to as destructive interference). The respective fundamental frequency signals at the third port of the quadrature hybrid 224 will be in phase with each other thus enhancing the resultant signal (commonly referred to as construction interference). The resultant signal is then terminated by the 50 $\Omega$ resistor 226. It should be appreciated then at the second harmonic frequency, $2f_o$ the second harmonic signal at the first port of the quadrature hybrid 224 is transferred equally to the second and third ports with the resultant signal at the second port having a phase that leads by 180° the resultant signal at the third port. Likewise, the second harmonic signal at the fourth port of the quadrature hybrid 224 is transferred equally to the second and third ports with the resultant signal at the second port having a phase that lags by 180° the phase of the resultant signal at the third port. It should now be apparent, since the respective signals at the first and fourth ports of quadrature hybrid 224 were 180° out-of-phase with each other, then the respective second harmonic signals when combined at the second port add with each other. Likewise, the respective second harmonic signals at the third port when combined at the third port add with each other. The signal at the third port is then terminated by the 50 $\Omega$ resistor 226.

The resultant signal having a frequency, $2f_o$, at the second port of the quadrature hybrid 224 is fed to a high pass filter 228 which provides a signal path for the signal with a frequency two times the frequency of the input signal while preventing signals below the frequency band pass from passing through. The signal at the output of the high pass filter 228 is fed to the input of the amplifier 210. The amplifier 210 operates in a manner similar to that described for amplifier 10 of FIGS. 1, 2 and 3. The output of the amplifier 210 provides the output of the frequency doubler 200. With such an arrangement, a frequency doubler 200 is provided which provides a relatively constant signal level at the output thereof.

Having described this invention, it will now be apparent to one of skill in the art that various elements of the signal generating circuitry may be changed without affecting this invention. Furthermore, the values of the capacitors and the inductors could be changed to accommodate the frequency range of interest. It is felt, therefore, that this invention should not be restricted to its disclosed embodiment, but rather should be limited only by the scope of the appended claims.

**Claims**

1. A frequency multiplier comprising:

   multiplying means, having an input and an output, for providing an output signal at the output, the output signal having a frequency of an odd multiple or an even multiple of a frequency of a signal fed to the input thereof; and characterised by an amplifier circuit (10) comprising:

(i) a first amplifier (12) having an input and an output, the input coupled to the output of the multiplier means;

(ii) an attenuator (16), having an input port, an output port and a control port, the input port fed by the output of the first amplifier (12);

(iii) means (20) for providing an intermediate control signal in response to variations in an output signal fed from the output of the first amplifier (12);

(iv) means (26) for providing a reference signal, the reference signal indicative of ambient temperature of the amplifier circuit (10); and

(v) means (24), fed by the reference signal and the intermediate control signal, for providing a control signal to the control port for minimizing variations of signal level in an output signal at the output port of the attenuator (16).

2. A frequency multiplier according to claim 1, characterised in that the frequency of the output signal is an odd multiple of the frequency of the signal fed to the input of the multiplying means and in that the multiplying means comprises a pair (136) of diodes, each one (136a, 136b) of the pair of diodes (136) having an anode and a cathode, with the anode of each diode connected to the cathode of the other diode.

3. A frequency multiplier according to claim 1, characterised in that the frequency of the output signal is an even multiple of the frequency of the signal fed to the input of the multiplying means, and in that the multiplying means comprises:

(a) a first quadrature hybrid (216) having a first port as an input port and a second and a third port as output ports, the first port being the input of the multiplying means;

(b) a second quadrature hybrid (224) having a first and a fourth port as input ports and a second and a third port as output ports, the first port of the second quadrature hybrid (224) coupled to the second port of the first quadrature hybrid (216) and the fourth port of the second quadrature hybrid (224) coupled to the third port of the first quadrature hybrid (216), the second port of the second quadrature hybrid (224) being the output of the multiplying means;

(c) a first diode (218) and a second diode (220), each diode having an anode and a cathode, the cathode of the first diode (218) connected to the cathode of the second diode (224) and to ground, the anode of the first diode (218) connected to a junction between the second port of the first quadrature hybrid (216) and the first port of the second quadrature hybrid (224) and the anode of the second diode (220) connected to a junction between the third port of the first quadrature hybrid (216) and the fourth port of the second quadrature hybrid (224).

4. A frequency multiplier according to claim 3, characterised in that the first quadrature hybrid (216) comprises a fourth port, the frequency multiplier further comprising a first resistor (222) and a second resistor (226), the first resistor (222) disposed between the fourth port of the first quadrature hybrid (216) and ground and the second resistor (226) disposed between the third port of the second quadrature hybrid (224) and ground.

5. A frequency multiplier according to any preceding claim, characterised by a highpass filter (138; 228) having an input and an output with the input of the highpass filter connected to the output of the multiplying means and the output of the highpass filter connected to the input of the amplifier circuit (110; 210).

6. A frequency multiplier according to claim 5, characterised by an input amplifier (132; 212) having an input and an output, the output of the input amplifier coupled to the input of the multiplying means.

7. A frequency multiplier according to claim 6, characterised by a matching network (134; 214) having an input and an output, the input of the matching network connected to the output of the input amplifier (132; 212) and the output of the matching network connected to the input of the multiplying means.

8. A frequency multiplier according to claim 7, characterised by further comprising a second amplifier (118) having an input and an output, the input of the amplifier (118) fed by the output port of the attenuator (116).

9. A frequency multiplier according to claim 8, characterised in that the means for providing an intermediate control signal comprises:

(a) a detector circuit (120) having an input and an output and including a Schottky diode detector; and

(b) means (114) for coupling a portion of the input signal fed to the input port of the attenuator (116) to the input of the detector circuit (120).

10. A frequency multiplier according to claim 9, characterised in that the means for providing a reference signal comprises:

(a) a temperature transducer (1Q5) having a first terminal and a second terminal;

(b) a first resistor (1R7) having a first terminal and a second terminal, the first terminal of the first resistor (1R7) connected to the first terminal of the temperature transducer (1Q5) and a voltage source and the second terminal of the first resistor (1R7) connected to the second terminal of the temperature transducer (1Q5); and

(c) a second resistor (1R3,1R4) having a first terminal and a second terminal, the first terminal of the second resistor connected to the second terminals of the temperature transducer (1Q5) and the first resistor (1R7) to provide the reference signal thereat and the second terminal of the second resistor connected to a voltage source return.

11. A frequency multiplier according to claim 10, characterised in that the means for providing the control signal to the control port comprises an operational amplifier (124).

**Patentansprüche**

1. Frequenzvervielfacher mit einer Multiplikationseinrichtung, die einen Eingang und einen Ausgang aufweist, zur Lieferung eines Ausgangssignals an dem Ausgang, wobei das Ausgangssignal eine Frequenz entsprechend einem ungeradzahligen Vielfachen oder einem geradzahligen Vielfachen einer Frequenz eines dem Eingang zugeführten Signals hat, gekennzeichnet durch eine Verstärkerschaltung (10), die folgendes enthält:

(i) einen ersten Verstärker (12) mit einem Eingang und einem Ausgang, wobei der Eingang mit dem Ausgang der Multiplikationseinrichtung gekoppelt ist;

(ii) eine Dämpfungseinrichtung (16), welche einen Eingangsanschluß, einen Ausgangsanschluß und einen Steueranschluß aufweist, wobei der Eingangsanschluß durch den Ausgang des ersten Verstärkers (12) gespeist wird;

(iii) Mittel (20) zur Lieferung eines Zwischen-Steuersignals in Abhängigkeit von Veränderungen eines Ausgangssignals, das von dem Ausgang des ersten Verstärkers (12) zugeführt wird;

(iv) Einrichtungen (26) zur Lieferung eines Bezugssignals, das für die Umgebungstemperatur der Verstärkerschaltung (10) repräsentativ ist; und

(v) Einrichtungen (24), welche durch das Bezugssignal und das Zwischen-Steuersignal beaufschlagt sind, zur Lieferung eines Steuersignals an den Steueranschluß, um Änderungen des Signalpegels im Ausgangssignal am Ausgangsanschluß der Dämpfungseinrichtung (16) minimal zu machen.

2. Frequenzvervielfacher nach Anspruch 1, dadurch gekennzeichnet, daß die Frequenz des Ausgangssignals ein ungeradzahliges Vielfaches der Frequenz des an den Eingang der Multiplikationseinrichtung geführten Eingangssignals ist und daß die Multiplikationseinrichtung ein Paar (136) von Dioden enthält, wobei jede (136a, 136b) des Paars von Dioden (136) eine Anode und eine Kathode aufweist und die Anode jeder Diode mit der Kathode der anderen Diode verbunden ist.

3. Frequenzvervielfacher nach Anspruch 1, dadurch gekennzeichnet, daß die Frequenz des Ausgangssignals ein geradzahliges Vielfaches der Frequenz des an den Eingang der Multiplikationseinrichtung geführten Signals ist und daß die Multiplikationseinrichtung folgendes enthält:

(a) ein erstes Quadraturhybrid (216), das einen ersten Anschluß als Eingangsanschluß und einen zweiten und dritten Anschluß als Ausgangsanschlüsse aufweist, wobei der erste Anschluß der Eingang der Multiplikationseinrichtung ist;

(b) ein zweites Quadraturhybrid (224) mit einem ersten und einem vierten Anschluß als Eingangsanschlüsse und einem zweiten und dritten Anschluß als Ausgangsanschlüsse, wobei der erste Anschluß des zweiten Quadraturhybrids (224) mit dem zweiten Anschluß des ersten Quadraturhybrids (216) gekoppelt ist und der vierte Anschluß des zweiten Quadraturhybrids (224) mit dem dritten Anschluß des ersten Quadraturhybrids (216) gekoppelt ist, und wobei der zweite Anschluß des zweiten Quadraturhybrids (224) der Ausgang der Multiplikationseinrichtung ist;

(c) eine erste Diode (218) und eine zweite Diode (220), wobei jede Diode eine Anode und eine Kathode aufweist, die Kathode der ersten Diode (218) mit der Kathode der zweiten Diode (224) und mit Erde gekoppelt ist, die Anode der ersten Diode (218) mit einem Verbindungspunkt zwischen dem zweiten Anschluß des ersten Quadraturhybrids (216) und dem ersten Anschluß des zweiten Quadraturhybrids (224) verbunden ist und die Anode der zweiten Diode (220) mit einem Verbindungspunkt zwischen dem dritten Anschluß des ersten Quadraturhybrids (216) und dem vierten Anschluß des zweiten Quadraturhybrids (224) verbunden ist.

4. Frequenzvervielfacher nach Anspruch 3, dadurch gekennzeichnet, daß das erste Quadraturhybrid (216) einen vierten Anschluß aufweist und daß der Frequenzvervielfacher weiter einen ersten Widerstand (222) und einen zweiten Widerstand (226) enthält, wobei der erste Widerstand (222) zwischen dem vierten Anschluß des ersten Quadraturhybrids (216) und Erde liegt und der zweite Widerstand (226) zwischen dem dritten Anschluß des zweiten Quadraturhybrids (224) und Erde liegt.

5. Frequenzvervielfacher nach irgendeinem vorhergehenden Anspruch, gekennzeichnet durch ein Hochpaßfilter (138; 228) mit einem Eingang und einem Ausgang, wobei der Eingang des Hochpaßfilters mit dem Ausgang der Multiplikationseinrichtung verbunden ist und der Ausgang des Hochpaßfilters mit dem Eingang der Verstärkerschaltung (110; 210) verbunden ist.

6. Frequenzvervielfacher nach Anspruch 5, gekennzeichnet durch einen Eingangsverstärker (132; 212) mit einem Eingang und einem Ausgang, wobei der Ausgang des Eingangsverstärkers mit dem Eingang der Multiplikationseinrichtung gekoppelt ist.

7. Frequenzvervielfacher nach Anspruch 6, gekennzeichnet durch eine Anpassungsschaltung (134; 214) mit einem Eingang und einem Ausgang, wobei der Eingang der Anpassungsschaltung mit dem Ausgang des Eingangsverstärkers (132; 212) verbunden ist und der Ausgang der Anpassungsschaltung mit dem Eingang der Multiplikationseinrichtung verbunden ist.

8. Frequenzvervielfacher nach Anspruch 7, dadurch gekennzeichnet, daß er weiter einen zweiten Verstärker (118) mit einem Eingang und einem Ausgang enthält, wobei der Eingang des Verstärkers (118) durch den Ausgangsanschluß der Dämpfungseinrichtung (116) gespeist wird.

9. Frequenzvervielfacher nach Anspruch 8, dadurch gekennzeichnet, daß die Mittel zur Lieferung eines Zwischen-Steuersignals folgendes enthalten:

(a) eine Detektorschaltung (120) mit einem Eingang und einem Ausgang sowie mit einem Schottky-Dioden-Detektor; und

(b) Mittel (114) zur Ankopplung eines Teils des dem Eingangsanschluß der Dämpfungseinrichtung (116) zugeführten Eingangssignals an den Eingang der Detektorschaltung (120).

10. Frequenzvervielfacher nach Anspruch 9, dadurch gekennzeichnet, daß die Einrichtungen zur Lieferung eines Bezugssignals folgendes enthalten:

(a) einen Temperaturwandler (1Q5) mit einem ersten Anschluß und einem zweiten Anschluß;

(b) einen ersten Widerstand (1R7) mit einem ersten Anschluß und einem zweiten Anschluß, wobei der erste Anschluß des ersten Widerstands (1R7) mit dem ersten Anschluß des Temperaturwandlers (1Q5) und einer Spannungsquelle verbunden ist und der zweite Anschluß des ersten Widerstands (1R7) mit dem zweiten Anschluß des Temperaturwandlers (1Q5) verbunden ist; und

(c) einen zweiten Widerstand (1R3, 1R4) mit einem ersten Anschluß und einem zweiten Anschluß, wobei der ersten Anschluß des zweiten Widerstands mit dem zweiten Anschluß des Temperaturwandlers (1Q5) und dem ersten Widerstand (1R7) verbunden ist, um das Bezugssignal dort abzugeben, und der zweite Anschluß des zweiten Widerstands mit einer Spannungsquellen-Rückleitung verbunden ist.

11. Frequenzvervielfacher nach Anspruch 10, dadurch gekennzeichnet, daß die Einrichtungen zur Lieferung des Steuersignals an den Steueranschluß einen Operationsverstärkers (124) enthalten.

**Revendications**

1. Multiplicateur de fréquence comprenant:
   un moyen de multiplication, ayant une entrée et une sortie, pour fournir un signal de sortie à la sortie, le signal de sortie ayant une fréquence qui est un multiple impair ou un multiple pair de la fréquence d'un signal appliqué à son entrée; et caractérisé par un circuit amplificateur (10) comprenant:

   (i) un premier amplificateur (12) ayant une entrée et une sortie, l'entrée étant couplée à la sortie du moyen formant multiplicateur;
   (ii) un atténuateur (16), ayant un accès d'entrée, un accès de sortie et un accès de commande, l'accès d'entrée étant alimenté par la sortie du premier amplificateur (12);
   (iii) un moyen (20) pour fournir un signal de commande intermédiaire en réponse à des variations d'un signal de sortie appliqué à partir de la sortie du premier amplificateur (12);
   (iv) un moyen (26) pour fournir un signal de référence, le signal de référence étant indicateur de la température ambiante du circuit amplificateur (10); et

(v) un moyen (24), alimenté par le signal de référence et le signal de commande intermédiaire, pour fournir un signal de commande à l'accès de commande en vue de minimiser les variations du niveau de signal dans un signal de sortie à l'accès de sortie de l'atténuateur (16).

2. Multiplicateur de fréquence selon la revendication 1, caractérisé en ce que la fréquence du signal de sortie est un multiple impair de la fréquence du signal appliqué à l'entrée du moyen de multiplication et en ce que le moyen de multiplication comprend une paire (136) de diodes, chaque diode (136a, 136b) de la paire de diodes (136) ayant une anode et une cathode, l'anode de chaque diode étant connectée à la cathode de l'autre diode.

3. Multiplicateur de fréquence selon la revendication 1, caractérisé en ce que la fréquence du signal de sortie est un multiple pair de la fréquence du signal appliqué à l'entrée du moyen de multiplication, et en ce que le moyen de multiplication comprend:

(a) un premier circuit hybride en quadrature ayant un premier accès en tant qu'accès d'entrée et un deuxième et un troisième accès en tant qu'accès de sortie, le premier accès étant l'entrée du moyen de multiplication;
(b) un deuxième circuit hybride en quadrature (224) ayant un premier et un quatrième accès en tant qu'accès d'entrée et un deuxième et un troisième accès en tant qu'accès de sortie, le premier accès du deuxième circuit hybride en quadrature (224) étant couplé au deuxième accès du premier circuit hybride en quadrature (216) et le quatrième accès du deuxième circuit hybride en quadrature (224) étant couplé au troisième accès du premier circuit hybride en quadrature (216), le deuxième accès du deuxième circuit hybride en quadrature (224) étant la sortie du moyen de multiplication;
(c) une première diode (218) et une deuxième diode (220), chaque diode ayant une anode et une cathode, la cathode de la première diode (218) étant connectée à la cathode de la deuxième diode (224) et à la masse, l'anode de la première diode (218) étant connectée à la jonction entre le deuxième accès du premier circuit hybride en quadrature (216) et le premier accès du deuxième circuit hybride en quadrature (224) et l'anode de la deuxième diode (220) étant connectée à la jonction entre le troisième accès du premier circuit hybride en quadrature (216) et le quatrième accès du deuxième circuit hybride en quadrature (224).

4. Multiplicateur de fréquence selon la revendication 3, caractérisé en ce que le premier circuit hybride en quadrature (216) comprend un quatrième accès, le multiplicateur de fréquence comprenant en outre une première résistance (222) et une deuxième résistance (226), la première résistance (222) étant disposée entre le quatrième accès du premier circuit hybride en quadrature (216) et la masse et la deuxième résistance (226) étant disposée entre le troisième accès du deuxième circuit hybride en quadrature (224) et la masse.

5. Multiplicateur de fréquence selon l'une quelconque des revendications précédentes, caractérisé par un filtre passe-haut (138; 228) ayant une entrée et une sortie, l'entrée du filtre passe-haut étant connectée à la sortie du moyen de multiplication et la sortie du filtre passe-haut étant connectée à l'entrée du circuit amplificateur (110; 210).

6. Multiplicateur de fréquence selon la revendication 5, caractérisé par un amplificateur d'entrée (132; 212) ayant une entrée et une sortie, la sortie de l'amplificateur d'entrée étant couplée à l'entrée du moyen de multiplication.

7. Multiplicateur de fréquence selon la revendication 6, caractérisé par un réseau d'adaptation (134; 214) ayant une entrée et une sortie, l'entrée du réseau d'adaptation étant connectée à la sortie de l'amplificateur d'entrée (132; 212) et la sortie du réseau d'adaptation étant connectée à l'entrée du moyen de multiplication.

8. Multiplicateur de fréquence selon la revendication 7, caractérisé en ce qu'il comprend en outre un deuxième amplificateur (118) ayant une entrée et une sortie, l'entrée de l'amplificateur (118) étant alimentée par l'accès de sortie de l'atténuateur (116).

9. Multiplicateur de fréquence selon la revendication 8, caractérisé en ce que le moyen pour fournir un signal de commande intermédiaire comprend:

(a) un circuit détecteur (120) ayant une entrée et une sortie et comportant un détecteur à diode de Schottky; et
(b) un moyen (114) pour coupler une partie du signal d'entrée appliqué à l'accès d'entrée de l'atténuateur (116), à l'entrée du circuit détecteur (120).

10. Multiplicateur de fréquence selon la revendication 9, caractérisé en ce que le moyen pour fournir un signal de référence comprend:

(a) un transducteur ($1Q_5$) de température ayant une première borne et une deuxième borne;
(b) une première résistance (1R7) ayant une première borne et une deuxième borne, la première borne de la première résistance (1R7) étant connectée à la première borne du transducteur ($1Q_5$) de température et à une source de tension et la deuxième borne de la première résistance (1R7) étant connectée à la deuxième borne du transducteur ($1Q_5$) de température; et

(c) une deuxième résistance (1R3, 1R4) ayant une première borne et une deuxième borne, la première borne de la deuxième résistance étant connectée aux deuxièmes bornes du transducteur ($1Q_5$) de température et de la première résistance (1R7) pour obtenir le signal de référence à celle-ci et la deuxième borne de la deuxième résistance étant connectée à un retour de source de tension.

11. Multiplicateur de fréquence selon la revendication 10, caractérisé en ce que le moyen pour fournir le signal de commande à l'accès de commande comprend un amplificateur opérationnel (124).

Fig. 1

EP 0 521 652 B1

*Fig. 2*

Fig. 3

_Fig. 4_

*Fig. 5*

Fig. 6

EP 0 521 652 B1

_Fig. 7_

EP 0 521 652 B1